# EUROPEAN PATENT APPLICATION

(11) **EP 4 318 616 A1**
(43) Date of publication of application: **07.02.2024**
(21) Application number: 22775716.8
(22) Date of filing: 23.03.2022
(51) Int. Cl.: H01L 33/48, G09F 9/00, G09F 9/33

(54) **METHOD FOR MANUFACTURING DISPLAY DEVICE**

(30) Priority: 26.03.2021 JP 2021054138
(71) Applicant: Dexerials Corporation, Shimotsuke-shi, Tochigi 323-0194 (JP); SHIN-ETSU CHEMICAL CO., LTD., Tokyo 1000005 (JP)
(72) Inventor: NODA, Daiki, Shimotsuke-shi, Tochigi 323-0194 (JP); TSUKAO, Reiji, Shimotsuke-shi, Tochigi 323-0194 (JP); SHIRAIWA, Toshiki, Shimotsuke-shi, Tochigi 323-0194 (JP); WATANABE, Kazumu, Shimotsuke-shi, Tochigi 323-0194 (JP); HAYASHI, Naoki, Shimotsuke-shi, Tochigi 323-0194 (JP); YAMAOKA, Hiroshi, Yokohamashi, Kanagawa 234-0053 (JP); NAKADA, Satoki, Tokyo 103-8577 (JP); SAITO, Takeshi, Yokohamashi, Kanagawa 234-0053 (JP); UEMORI, Nobutaka, Yokohamashi, Kanagawa 234-0053 (JP)
(74) Representative: Müller-Boré & Partner Patentanwälte PartG mbB
(86) International application number: PCT/JP2022/013684
(87) International publication number: WO 2022/202934

(57) **Abstract**

Provided is a method of manufacturing a display device capable of reducing tact time. The method includes: a transfer step of arranging an anisotropic conductive adhesive layer provided on a base material that is transparent to laser light and a wiring board to face each other, and irradiating laser light from the base material side so that individual pieces of the anisotropic conductive adhesive layer are transferred to and arranged at predetermined positions on the wiring board; and a mounting step of mounting light-emitting elements on the individual pieces arranged at the predetermined positions on the wiring board. The individual pieces of the anisotropic conductive adhesive layer are able to be transferred and arranged with high precision and high efficiency by irradiation of laser light.

## Description

### TECHNICAL FIELD

The present technology relates to a method of manufacturing a display device including an array of light-emitting elements. In particular, the present technology relates to a method of manufacturing a display device including an array of LED elements such as mini-LEDs and micro-LEDs. This application claims priority on the basis of Japanese Patent Application No. 2021-054138, filed on March 26, 2021 in Japan, which is incorporated by reference in this application.

### BACKGROUND ART

Conventionally, a display device has been proposed in which a plurality of light-emitting elements such as LEDs (light-emitting diodes) are arranged to form a light-emitting element array. Patent Document 1 discloses a method of joining LEDs by using anisotropic conductive adhesives such as ACF (anisotropic conductive film).

In the method described in Patent Document 1, the adhesive resin and conductive particles of the ACF remain between individual LEDs because the ACF is collectively attached to the device mounting surface of the substrate. This prevents light transmission, so that excellent light transmission cannot be achieved even when light transmission is required for the light-emitting element array.

Another method that applies the ACF only directly under the LED requires a considerable amount of time just to apply the ACF, resulting in a longer tact time.

### CITATION LIST

### PATENT LITERATURE

Patent Document 1: US 2015/0255505 A1

### SUMMARY OF INVENTION

### TECHNICAL PROBLEM

The present technology was proposed in view of such conventional circumstances, and provides a method of manufacturing a display device capable of reducing the tact time.

### SOLUTION TO PROBLEM

A method of manufacturing a display device according to an aspect of the present technology includes: a transfer step of arranging an anisotropic conductive adhesive layer provided on a base material that is transparent to laser light and a wiring board to face each other, and irradiating laser light from the base material side so that individual pieces of the anisotropic conductive adhesive layer are transferred to and arranged at predetermined positions on the wiring board; and a mounting step of mounting light-emitting elements on the individual pieces arranged at the predetermined positions on the wiring board.

A method of manufacturing a display device according to an aspect of the present technology includes: a transfer step of arranging an anisotropic conductive adhesive layer provided on a base material that is transparent to laser light and light-emitting elements arranged on a transfer substrate to face each other, and irradiating laser light from the base material side to transfer individual pieces of the anisotropic conductive adhesive layer to the light-emitting elements arranged on the transfer substrate; a retransfer step of retransferring the light-emitting elements to which the individual pieces have been transferred to the wiring board; and a mounting step of mounting the light-emitting elements arranged at predetermined positions on the wiring board via the individual pieces.

### ADVANTAGEOUS EFFECTS OF INVENTION

According to the present technology, individual pieces of the anisotropic conductive adhesive layer are able to be transferred and arranged with high precision and high efficiency by irradiation of laser light, thereby reducing the tact time.

### BRIEF DESCRIPTION OF DRAWINGS

FIG. 1 is a cross-sectional view schematically illustrating an anisotropic conductive adhesive layer provided on a base material and a wiring board facing each other.
FIG. 2 is a cross-sectional view schematically illustrating a state in which individual pieces of the anisotropic conductive adhesive layer are transferred to and arranged at predetermined positions on the wiring board by laser irradiation from the base material side.
FIG. 3 is a cross-sectional view schematically illustrating a state in which light-emitting elements are mounted on the individual pieces arranged at predetermined positions on the wiring board.
FIG. 4 is a cross-sectional view schematically illustrating a state in which individual pieces of an anisotropic conductive adhesive layer are transferred to and arranged at electrode positions on a wiring board by laser irradiation from the base material side.
FIG. 5 is a cross-sectional view schematically illustrating a state in which light-emitting elements are mounted on individual pieces arranged in units of electrodes on the wiring board.
FIG. 6 is a cross-sectional view schematically illustrating an anisotropic conductive adhesive layer provided on a base material and light-emitting elements arranged on a transfer substrate facing each other.
FIG. 7 is a cross-sectional view schematically illustrating an anisotropic conductive adhesive layer provided on a base material.
FIG. 8 is a cross-sectional view schematically illustrating a state in which laser light is irradiated from the base material side and individual pieces of the anisotropic conductive adhesive layer are transferred to light-emitting elements arranged on the transfer substrate.
FIG. 9 is a cross-sectional view schematically illustrating a state in which the light-emitting elements to which individual pieces have been transferred are retransferred to a wiring board.
FIG. 10 is a metal micrograph showing the individual pieces of the anisotropic conductive adhesive layer arranged on a blank glass plate.
FIG. 11 is a magnified view of the metal micrograph shown in FIG. 4.

### DESCRIPTION OF EMBODIMENTS

Preferred embodiments of the present technology will be described in detail in the following order with reference to the drawings.

### 1. METHOD OF MANUFACTURING DISPLAY DEVICE

### 2. EXAMPLES

### 1. METHOD OF MANUFACTURING DISPLAY DEVICE

### FIRST EMBODIMENT

The method of manufacturing a display device according to the first embodiment includes: a transfer step of arranging an anisotropic conductive adhesive layer provided on a base material that is transparent to laser light and a wiring board to face each other, and irradiating laser light from the base material side so that individual pieces of the anisotropic conductive adhesive layer are transferred to and arranged at predetermined positions on the wiring board; and a mounting step of mounting light-emitting elements on the individual pieces arranged at the predetermined positions on the wiring board. Thus, the individual pieces of the anisotropic conductive adhesive layer are able to be transferred and arranged with high precision and high efficiency by irradiation of laser light, thereby reducing the tact time.

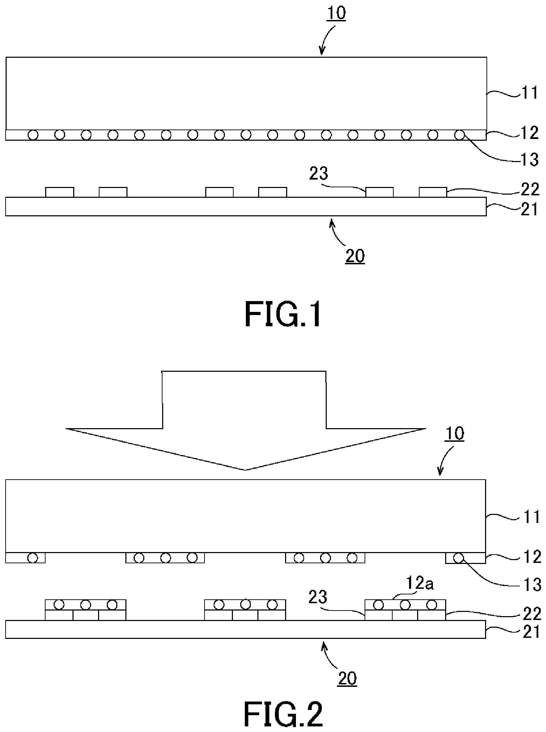

The following describes, with reference to FIGS. 1 to 3, a transfer step (A) in which individual pieces of the anisotropic conductive adhesive layer are transferred to and arranged at predetermined positions on the wiring board, and a mounting step (B) in which light-emitting elements are mounted on the individual pieces arranged at the predetermined positions on the wiring board.

### TRANSFER STEP (A)

FIG. 1 is a cross-sectional view schematically illustrating an anisotropic conductive adhesive layer provided on a base material and a wiring board facing each other. First, as shown in FIG. 1, in the transfer step (A), an anisotropic conductive adhesive layer substrate 10 and a wiring board 20 are made to face each other.

The anisotropic conductive adhesive layer substrate 10 includes a base material 11 and an anisotropic conductive adhesive layer 12, the anisotropic conductive adhesive layer 12 being provided on the surface of the base material 11. The base material 11 may be any material that is transparent to laser light, preferably quartz glass with high optical transmittance over all wavelengths.

The anisotropic conductive adhesive layer 12 contains, e.g., conductive particles 13 in a binder. In addition, from the viewpoint of the transferability by the laser, it is preferred that the anisotropic conductive adhesive layer 12 is configured such that the conductive particles 13 are aligned in a surface direction so as to achieve conduction and avoid short circuit. The alignment of the conductive particles is preferably a regular alignment. An example is described in JP 6119718 B. Examples of binders include epoxy adhesives and acrylic adhesives, among which an epoxy adhesive containing a resin having a maximum absorption wavelength in the wavelength range of 180 to 360 nm or a high-purity bisphenol A type epoxy resin may be preferably used. Specific examples of high-purity bisphenol A type epoxy resin may include "YL 980" available from Mitsubishi Chemical Corporation. As the epoxy resin hardener contained in the epoxy adhesive, a cationic polymerization initiator such as an aromatic sulfonium salt or an anionic polymerization initiator may be preferably used. Specific examples of cationic polymerization initiators based on aromatic sulfonium salts may include "SI-60L" available from Sanshin Chemical Industry. The acrylic adhesive is an adhesive that utilizes a radical polymerization reaction, and contains, e.g., a radical polymerizable substance such as a (meth) acrylate compound and a radical polymerization initiator such as a peroxide. Epoxy adhesives are preferred from the viewpoint of heat resistance and adhesion required for use in display devices. Although a thermosetting type anisotropic conductive adhesive layer has been described here, a photosetting type anisotropic conductive adhesive layer may be used, for example, when heat is to be avoided in subsequent processes. In this case, a photopolymerization initiator may be used instead of the thermopolymerization initiator described above.

As the conductive particles 13, those used in known anisotropic conductive films may be selected as appropriate. For example, examples may include metal particles such as nickel (melting point: 1,455 °C), copper (melting point: 1,085 °C), silver (melting point: 961.8 °C), gold (melting point: 1,064 °C), palladium (melting point: 1,555 °C), tin (melting point: 231.9 °C), nickel boride (melting point: 1,230 °C), ruthenium (melting point: 2,334 °C), and tin alloy solder; metal-coated resin particles formed by coating a polymer containing at least one monomer selected from polyamide, polybenzoguanamine, styrene, and divinylbenzene as a monomer unit with a metal such as nickel, copper, silver, gold, palladium, tin, nickel boride, and ruthenium; and metal-coated inorganic particles formed by coating inorganic particles such as silica, alumina, barium titanate, zirconia, carbon black, silicate glass, borosilicate glass, lead glass, soda-lime glass, and alumina-silicate glass with a metal such as nickel, copper, silver, gold, palladium, tin, nickel boride, and ruthenium. The metal particles may be coated with the metal described above. The metal layer in the metal-coated resin particles and the metal-coated inorganic particles may be a single layer or formed of a plurality of layers of different metals.

Insulation coating may be applied by coating these conductive particles with, e.g., a resin layer or insulating particles such as resin particles or inorganic particles. The particle size of the conductive particles 13 may be appropriately selected according to the area of electrodes and bumps of the optical element and the wiring board to be mounted, but is preferably 1 to 30 µm, more preferably 1 to 10 µm, and particularly preferably 1 to 3 µm. When used for mounting micro-LED devices, due to the small area of electrodes and bumps, this particle size is preferably 1 to 2.5 µm, more preferably 1 to 2.2 µm, and particularly preferably 1 to 2 µm. The particle size may be determined by measuring more than 200 particle sizes through microscopic observation (e.g., light microscopes, metal microscopes, and electron microscopes) and calculating the average of the sizes.

In addition, the coating thickness of the metal in the conductive particles in which the metal is coated on the resin particles or the inorganic particles as described above is preferably 0.005 µm or more, more preferably 0.01 µm or more, preferably 10 µm or less, more preferably 1 micrometer or less, and even more preferably 0.3 µm or less. In the case where the metal coating is multi-layered, this coating thickness is the thickness of the entire metal coating. The coating thickness within the range defined by the lower and upper limits described above can easily achieve sufficient conductivity and can take advantage of the properties of the resin particles and inorganic particles mentioned above without making the conductive particles too hard.

The coating thickness may be measured, e.g., by observing cross-sections of conductive particles by using a transmission electron microscope (TEM). Regarding the above coating thickness, it is preferable to calculate the average value of five arbitrary coating thicknesses as the coating thickness of one conductive particle, and it is more preferable to calculate the average value of the total coating thickness as the coating thickness of one conductive particle. The above coating thickness is preferably obtained by calculating the average coating thickness of each conductive particle for ten arbitrary conductive particles.

The shapes of conductive particles include spherical, ellipsoidal, spiky, and indefinite shapes. Among these, spherical conductive particles are preferred because the particle size and size distribution of spherical conductive particles may be easily controlled. These conductive particles may have protrusions on their surfaces to improve connectivity.

Although the film thickness of the anisotropic conductive adhesive layer is appropriately selected depending on the height of the electrode or bump of the optical element or wiring board to be mounted, it is preferred that the film thickness is 1 to 30 µm and more preferably 1 to 10 µm. When used for mounting micro-LED devices, this film thickness is preferably 1 to 6 µm, more preferably 1 to 5 µm, and particularly preferably 1 to 4 µm due to the low height of the electrodes and bumps.

By forming the anisotropic conductive adhesive layer into a film, it becomes easy to provide the anisotropic conductive adhesive layer on the base material. From the viewpoint of ease of handling, it is preferred to provide a releasable film such as a polyethylene terephthalate film on one or both sides of the anisotropic conductive adhesive layer.

An anisotropic conductive adhesive layer may be stacked on the base material by transferring the anisotropic conductive adhesive layer of these film-shaped anisotropic conductive adhesive layers to the base material, or an anisotropic conductive adhesive layer may be stacked on the base material by forming the anisotropic conductive adhesive layer on the base material. The methods of forming the anisotropic conductive adhesive layer on the base material may include a method of applying and drying a solution of an anisotropic conductive adhesive on the base material and a method of forming an adhesive layer containing no conductive particles on the base material and fixing conductive particles to the resulting adhesive layer.

The wiring board 20 includes a first conductivity-type circuit pattern and a second conductivity-type circuit pattern on the base material 21, and has a first electrode 22 and a second electrode 23 at positions respectively corresponding to, e.g., a first conductivity-type electrode on the p-side and a second conductivity-type electrode on the n-side so that light-emitting elements are arranged in units of subpixels constituting one pixel. In addition, the wiring board 20 forms a circuit pattern of, e.g., data lines or address lines of matrix wiring, and enables the light emitting elements corresponding to each subpixel constituting one pixel to be turned on and off. A pixel may consist of, e.g., three subpixels of RGB (red, green, and blue), four subpixels of RGBW (red, green, blue, and white) or RGBY (red, green, blue, and yellow), or two subpixels of RG or GB. The wiring board 20 is preferably a translucent board, the base material 21 is preferably glass or PET (polyethylene terephthalate), among others, and the circuit pattern, the first electrode 22, and the second electrode 23 are preferably transparent conductive films such as ITO (indium-tin-oxide), IZO (indium-zinc-oxide), ZnO (zinc-oxide), and IGZO (indium-gallium-zinc-oxide).

FIG. 2 is a cross-sectional view schematically illustrating a state in which individual pieces of an anisotropic conductive adhesive layer are transferred to and arranged at predetermined positions on a wiring board by laser irradiation from the base material side. As shown in FIG. 2, in the transfer step (A), laser light is irradiated from the base material 11 side, and the individual pieces 12a of the anisotropic conductive adhesive layer 12 are transferred to and arranged at predetermined positions on the wiring board 21.

In order to efficiently transfer the individual pieces of the anisotropic conductive adhesive layer from the base material, the anisotropic conductive adhesive layer provided on the base material may be pretreated and formed so that the individual pieces are arranged in a matrix. Such pretreatments may include providing lattice-like notches in the anisotropic conductive adhesive layer in which a plurality of longitudinal and lateral notches intersect. The notches may be made by mechanical or chemical methods. Of course, the notches may be made by burning the anisotropic conductive adhesive layer by laser light. Such a treatment may cause the individual pieces of the plurality of anisotropic conductive adhesive layers to be arranged in a matrix on the base material and easily transferred by laser light. It should be noted that these notches do not necessarily have to be deep until the base material is exposed, and even shallow notches that do not expose the substrate can improve transferability by laser light. Such pretreatment may be performed after the formation of the anisotropic conductive adhesive layer on the base material or before the formation of the anisotropic conductive adhesive layer on the base material, i.e., in the state of a film-shaped anisotropic conductive adhesive layer.

In the transfer step (A), the individual pieces 12a of the anisotropic conductive adhesive layer 12 may be arranged in units of one pixel (e.g., one pixel that is a set of RGB) or in units of subpixels (e.g., any one of R, G, and B) that constitute one pixel. This makes it possible to work with arrays of light emitting elements ranging from those with a high PPI (pixels per inch) to those with a low PPI.

In the transfer step (A), the individual pieces 12a of the anisotropic conductive adhesive layer 12 are preferably arranged in units of one pixel or more pixels. For example, in the case of RGB, since the light-emitting elements are arranged as a set of three pixels or a set of six pixels in total including three pixels of RGB redundant circuits, the anisotropic conductive film may be transferred to six pixels in a set, transferred in units of one pixel, or even arranged in units of electrodes. Moreover, in order to improve productivity, an anisotropic conductive film may be transferred within an area that does not affect transparency, such as 1 mm x 1 mm.

In the case where the individual pieces of the anisotropic conductive adhesive layer are arranged in units of one pixel, the film-shaped anisotropic conductive adhesive layer may be tape-shaped with a width equal to one pixel and the notches described above may be made in only one direction (in the width direction of the tape). The tape width of one pixel does not mean the same length as the size of one pixel, but a length that does not interfere with adjacent pixels, depending on the spacing between the pixels.

In addition, the distance between the individual pieces of the wiring board 20 arranged at predetermined positions is preferably 3 µm or more, more preferably 5 µm or more, and even more preferably 10 µm or more. The upper limit of the distance between the individual pieces is preferably 3,000 µm or less, more preferably 1,000 µm or less, and even more preferably 500 µm or less. If the distance between the individual pieces is too small, the method of attaching the anisotropic conductive film to the entire surface of the wiring board 20 is preferred, and if the distance between the individual pieces is too large, the method of attaching the anisotropic conductive film to predetermined positions of the wiring board 20 is preferred. The distance between the individual pieces may be measured by using microscopy (e.g., light microscopy, metal microscopy, and electron microscopy).

To transfer the individual pieces 12a of the anisotropic conductive adhesive layer 12, e.g., a LIFT (laser induced forward transfer) device may be used. The LIFT device includes, e.g., a telescope that collimates pulsed laser light emitted from a laser device into parallel light, a shaping optical system that uniformly shapes the spatial intensity distribution of the pulsed laser light that has passed through the telescope, a mask that allows the pulsed laser light shaped by the shaping optical system to pass through in a predetermined pattern, a field lens positioned between the shaping optical system and the mask, and a projection lens that reduces and projects the laser light that has passed through the pattern of the mask onto a donor substrate, and holds the anisotropic conductive adhesive layer substrate 10, which is a donor substrate, on a donor stage, and the wiring board 21, which is a receptor substrate, on a receptor stage. The distance between the anisotropic conductive adhesive layer 12 and the wiring board 20 is preferably 10 to 1,000 µm, more preferably 50 to 500 µm, and even more preferably 80 to 200 µm.

The laser device may be, for example, an excimer laser that emits laser light having a wavelength of 180 to 360 nm. The oscillation wavelengths of the excimer laser are, e.g., 193, 248, 308, and 351 nm, and one of these oscillation wavelengths may be appropriately selected according to the optical absorbance of the material of the anisotropic conductive adhesive layer 12.

The mask has a pattern in which an array of windows of a predetermined size is formed at a predetermined pitch so that the projection at the interface between the base material 11 and the anisotropic conductive adhesive layer 12 results in the desired array of laser light. The mask is patterned, e.g., by chromium-plating on the base material 11, so that the window area without chromium-plating transmits laser light and the area with chromium-plating blocks laser light.

The light emitted from the laser device enters the telescopic optical system and then propagates to the shaping optical system. The laser light just before entering the shaping optical system is collimated by the telescopic optical system so that it becomes generally parallel light at any position within the moving range of the X-axis of this donor stage; the parallel light always enters the shaping optical system at approximately the same size and angle (right angle).

The laser light passing through the shaping optical system enters the mask via the field lens that constitutes an image-side telecentric reduction projection optical system in combination with the projection lens. The laser light passing through the mask pattern changes its propagation direction vertically downward by an epi-illumination mirror and enters the projection lens. The laser light emitted from the projection lens enters from the side of the base material 11 and is accurately projected onto a predetermined position of the anisotropic conductive adhesive layer 12 formed on its surface (lower surface) in a reduced size of the mask pattern.

The pulse energy of the laser light imaged at the interface between the anisotropic conductive adhesive layer and the base material is preferably 0.001 to 2J, more preferably 0.01 to 1.5J, and even more preferably 0.1 to 1J. The fluence is preferably 0.001 to 2 J/cm², more preferably 0.01 to 1 J/cm², and even more preferably 0.05 to 0.5 J/cm². The pulse width (irradiation time) is preferably 0.01 to 1 x 10⁹ picoseconds, more preferably 0.1 to 1 x 10⁷ picoseconds, and even more preferably 1 to 1 x 10⁵ picoseconds. The pulse frequency is preferably 0.1 to 10,000 Hz, more preferably 1 to 1,000 Hz, and even more preferably 1 to 100 Hz. The number of irradiation pulses is preferably 1 to 30,000,000.

Such a lifting device can generate a shock wave in the anisotropic conductive adhesive layer 12 irradiated with laser light at the interface between the base material 11 and the anisotropic conductive adhesive layer 12 to cause the plurality of individual pieces 12a to be separated from the base material 11, lifted toward the wiring board 20, and landed at predetermined positions on the wiring board 20. Such a transfer method is called laser lift-off and is a method that uses, e.g., laser ablation. Thus, the individual pieces 12a of the anisotropic conductive adhesive layer 12 can be transferred to and arranged on the wiring board 20 with high precision and high efficiency, thereby reducing the tact time.

The reaction rate of the individual pieces 12a of the anisotropic conductive adhesive layer 12 after the transfer step (A) is preferably 25% or less, more preferably 20% or less, and even more preferably 15% or less. The reaction rate of the individual pieces 12a of 25% or less enables thermocompression bonding of the light-emitting elements in the mounting step (B). The reaction rate can be measured by using, e.g., FT-IR.

### MOUNTING STEP (B)

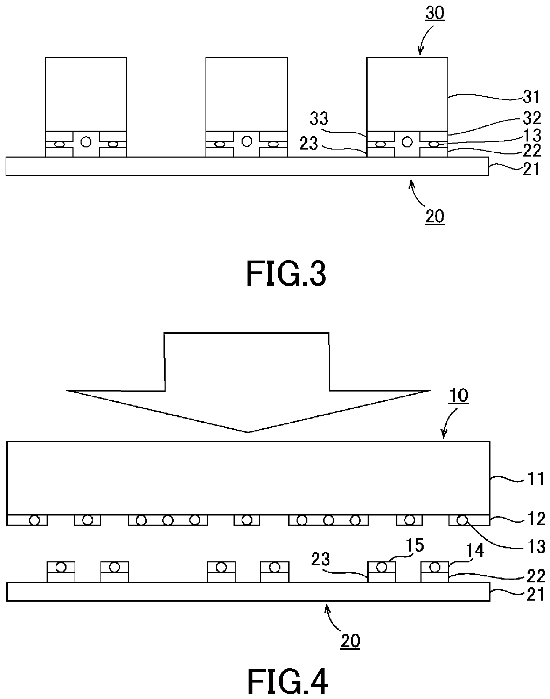

FIG. 3 is a cross-sectional view schematically illustrating a state in which light-emitting elements are mounted on individual pieces arranged at predetermined positions on a wiring board. As shown in FIG. 3, in the mounting step (B), light-emitting elements 30 are mounted on individual pieces 12a arranged at predetermined positions on the wiring board 20.

The light-emitting element 30 includes a body 31, a first conductivity-type electrode 32, and a second conductivity-type electrode 33, and has a horizontal structure in which the first conductivity-type electrode 32 and the second conductivity-type electrode 33 are arranged on the same plane side. The body 31 has a so-called double heterostructure with a first conductive cladding layer made of, e.g., n-GaN, an active layer made of, e.g., InₓAl_{y}Ga_{1-x-y}N, and a second conductive cladding layer made of, e.g., p-GaN. The first conductivity-type electrode 32 is formed in a part of the first conductivity-type cladding layer by a passivation layer, and the second conductivity-type electrode 33 is formed in a part of the second conductivity-type cladding layer. When a voltage is applied across the first conductivity-type electrode 32 and the second conductivity-type electrode 33, charge carriers are concentrated in the active layer and recombine, resulting in emission.

Methods of mounting the light-emitting elements 30 on the wiring board 20 may include, but are not limited to, a method of directly transferring and arranging the light-emitting elements 30 from the wafer board to the wiring board 20 by the laser lift-off method (LLO method), or a method of previously adhering the light-emitting elements 30 to a transfer substrate, and then transferring and placing the light-emitting elements 30 from the transfer substrate to the wiring board 20. As a method of thermocompression-bonding the light-emitting elements 30 to the wiring board 20, any of the connection methods used in known anisotropic conductive films may be selected as appropriate. Thus, the light-emitting elements 30 are able to be anisotropically connected on the wiring board 20 while the wiring board 20 is exposed without the presence of an anisotropic conductive adhesive layer between the light-emitting elements 30. In addition, by using a translucent board as the wiring board 20, superior optical transparency can be achieved compared to the case where an anisotropic conductive film is applied to the entire surface of the wiring board 20.

As described above, the method of manufacturing the display device according to the first embodiment can transfer and arrange the individual pieces 12a of the anisotropic conductive adhesive layer 12 to and on the wiring board 20 with high precision and high efficiency by irradiation of the laser light, thereby reducing the tact time. In the above described embodiment, a method of manufacturing a display device is exemplified, but the present technology is not limited thereto and can be applied to a method of manufacturing a light-emitting element as a light source, for example.

### MODIFICATION OF FIRST EMBODIMENT

As shown in FIG. 2, in the transfer step (A) of the first embodiment described above, the individual pieces 12a of the anisotropic conductive adhesive layer 12 are arranged on the wiring board 21 in units of multiple pixels, one pixel, or subpixels constituting one pixel; the arrangement, however, is not limited to the above and may be in units of electrodes, for example.

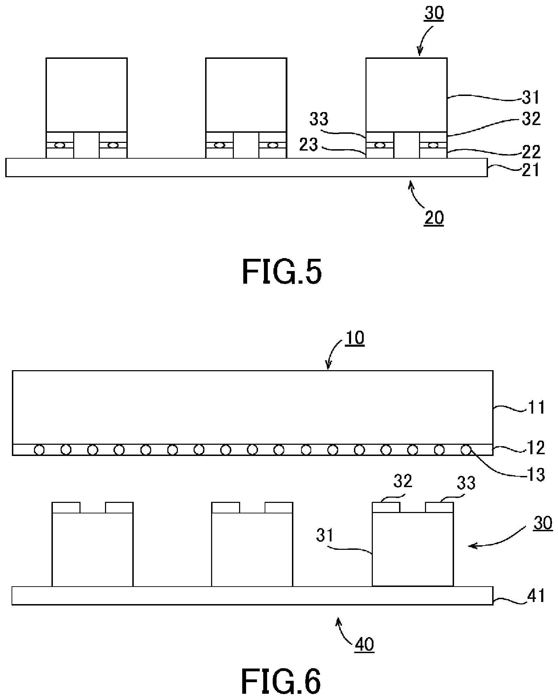

FIG. 4 is a cross-sectional view schematically illustrating a state in which individual pieces of an anisotropic conductive adhesive layer are transferred to and arranged at electrode positions on a wiring board by laser irradiation from the base material side, and FIG. 5 is a cross-sectional view schematically illustrating a state in which light-emitting elements are mounted on individual pieces arranged in units of electrodes on the wiring board.

In the transfer step (A), as shown in FIG. 4, the first individual piece 14 and the second individual piece 15 are transferred to the first electrode 22 and the second electrode 23 corresponding to, e.g., the first conductivity-type electrode 32 on the p-side and the second conductivity-type electrode 33 on the n-side of the light-emitting element 30, respectively, and in the mounting step (B), as shown in FIG. 5, the light-emitting elements 30 may be mounted on the individual pieces arranged on the wiring board 20 in units of electrodes. This can improve the transparency of the display device.

### SECOND EMBODIMENT

A method of manufacturing a display device according to the second embodiment includes: a transfer step of arranging an anisotropic conductive adhesive layer provided on a base material that is transparent to laser light and light-emitting elements arranged on a transfer substrate to face each other, and irradiating laser light from the base material side to transfer individual pieces of the anisotropic conductive adhesive layer to the light-emitting elements arranged on the transfer substrate; a retransfer step of retransferring the light-emitting elements to which the individual pieces have been transferred to the wiring board; and a mounting step of mounting the light-emitting elements arranged at predetermined positions on the wiring board via the individual pieces. The laser light irradiation can transfer and align the individual pieces of the anisotropic conductive adhesive layer with high precision and high efficiency, thereby reducing the tact time.

The following describes, with reference to FIGS. 6 to 9, a transfer step (A1) of transferring individual pieces of an anisotropic conductive adhesive layer to an light-emitting elements arranged on a transfer substrate, a retransfer step (A2) of retransferring the light-emitting elements to which the individual pieces have been transferred to the wiring board, and a mounting step (BB) of mounting the light-emitting elements arranged at predetermined positions on the wiring board via the individual pieces. It should be noted that the same components as in the first embodiment are designated by the same symbols, and their descriptions are omitted.

### TRANSFER STEP (A1)

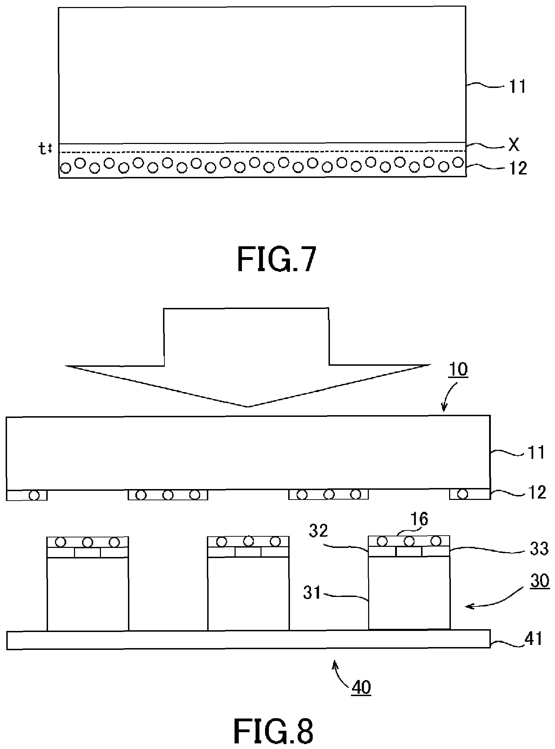

FIG. 6 is a cross-sectional view schematically illustrating an anisotropic conductive adhesive layer provided on a base material and light-emitting elements arranged on a transfer substrate facing each other, and FIG. 7 is a cross-sectional view schematically illustrating an anisotropic conductive adhesive layer provided on a base material. As shown in FIG. 6, first, in the transfer step (A1), the anisotropic conductive adhesive layer substrate 10 and a transfer substrate 40 are arranged to face each other.

The transfer substrate 40 includes a base material 41 and light-emitting elements 30 arranged on the base material 41.

The base material 41 is appropriately selected according to the transfer scheme of the retransfer step (A2) described later. For example, in the case of a transfer scheme that uses laser ablation, the base material 41 can be any material that is transparent to laser light, preferably quartz glass with high optical transmittance over all wavelengths. Furthermore, for example, a silicone rubber layer may be provided when the transfer substrate 40 is bonded to the wiring board 20 to adhere the light-emitting elements 30.

In the transfer step (A1), as in the first embodiment described above, a transfer method that uses laser ablation called laser lift-off may be used. When ablation is used, as shown in FIG. 7, it is preferred that the conductive particles are absent in the region X of the anisotropic conductive adhesive layer 12, which is 0 to 0.05 µm in the thickness direction from the surface on which the base material 11 is provided.

There is a strong influence of ablation in the region X of the anisotropic conductive adhesive layer 12, which is 0 to 0.05 µm in the thickness direction from the surface on which the base material 11 is provided. Therefore, it is preferred that conductive particles are absent in this region X. In other words, it is preferred for all conductive particles to be present in the portion of the anisotropic conductive adhesive layer outside of region X without protruding into region X. Here, the absence of conductive particles in a region means, e.g., not only the absence of the entire conductive particle in the region but also the absence of any part of the conductive particle.

From the viewpoint of the productivity of the anisotropic conductive adhesive layer, when conductive particles are inevitably contained in the region X, the number of conductive particles contained in the region X is preferably 5% or less and more preferably 1% or less of the total number of conductive particles contained in the anisotropic conductive adhesive layer.

Here, the thickness t of the region X of the anisotropic conductive adhesive layer 12 may be 0 to 0.05 µm in the thickness direction from the surface on which the base material 11 is provided, and in order to more reliably suppress the degradation of conductive particles due to ablation, the thickness t is set to 0 to 0.1 µm, more preferably 0 to 0.15 µm, especially preferably 0 to 0.2 µm, and the conductive particles are preferably absent in this area. In other words, it is preferred for all conductive particles to be present in the portion of the anisotropic conductive adhesive layer outside of these regions without protruding into these regions. Similarly, from the viewpoint of the productivity of the anisotropic conductive adhesive layer, when conductive particles are inevitably contained in these regions, the number of conductive particles contained in the regions is preferably 5% or less and more preferably 1% or less of the total number of conductive particles contained in the anisotropic conductive adhesive layer.

In addition, in order to enhance the ablation resistance of the conductive particles, it is preferred that the conductive particles are composed of metals including those having a melting point of 1,400 °C or higher among the metals constituting the conductive particles described above. It is preferred that the upper limit of the melting point is about 3,500 °C from the viewpoint of availability. From the same viewpoint, the metals constituting the conductive particles preferably contain nickel, palladium, or ruthenium.

When using the aforementioned metal-coated resin particles formed by coating resin particles with metal, or metal-coated inorganic particles formed by coating inorganic particles with metal, in order to minimize the influence of the ablation on the resin particles or the inorganic particles, the coating thickness of the metal is preferably 0.08 µm or more, more preferably 0.1 µm or more, particularly preferably 0.15 µm or more, and most preferably 0.2 µm or more. The upper limit of this coating thickness depends on the diameter of the conductive particles, but is preferably about 20% of the conductive particle diameter or 0.5 µm.

Such an anisotropic conductive adhesive layer is applicable not only to the second embodiment, but also to the first embodiment, its modification, and other configurations.

FIG. 8 is a cross-sectional view schematically illustrating a state in which laser light is irradiated from the base material side and individual pieces of the anisotropic conductive adhesive layer are transferred to light-emitting elements arranged on the transfer substrate. As shown in FIG. 8, in the transfer step (A1), laser light is irradiated from the base material 11 side, and individual pieces 16 of the anisotropic conductive adhesive layer 12 are transferred to and arranged at predetermined positions on the wiring board 21. The laser light is irradiated from the base material 11 side, and the individual pieces 16 of the anisotropic conductive adhesive layer 12 are transferred to the light-emitting elements 30 arranged on the transfer substrate.

As in the first embodiment described above, e.g., a lifting device can be used to transfer the individual pieces 16 of the anisotropic conductive adhesive layer 12. The lifting device can generate a shock wave in the anisotropic conductive adhesive layer 12 irradiated with laser light at the interface between the base material 11 and the anisotropic conductive adhesive layer 12 to cause the plurality of individual pieces 16 to be separated from the base material 11, lifted toward the light-emitting elements 30 arranged on the transfer substrate, and landed on the light-emitting elements 30 with high precision, thereby reducing the tact time.

### RETRANSFER STEP (A2)

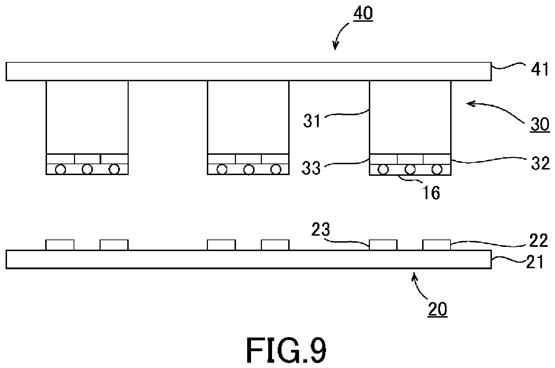

FIG. 9 is a cross-sectional view schematically illustrating a state in which the light-emitting elements to which individual pieces have been transferred are retransferred to a wiring board. As shown in FIG. 9, in the retransfer step (A2), the light-emitting elements 30 to which the individual pieces 16 have been transferred are retransferred to the wiring board. Methods of retransferring may include, but are not limited to, a method of directly transferring and arranging the light-emitting elements 30 on which the individual pieces 16 are transferred from the transfer substrate 40 to the wiring board 20 by the laser lift-off method (LLO method), or a method of previously adhering the light-emitting elements 30 to which the individual pieces 16 have been transferred to a transfer substrate, and then transferring and placing the light-emitting elements 30 from the transfer substrate 40 to the wiring board 20.

In the retransfer step (A2), the light-emitting elements 30 are preferably transferred in units of subpixels constituting one pixel. This makes it possible to work with arrays of light emitting elements ranging from those with a high PPI (pixels per inch) to those with a low PPI.

### MOUNTING STEP (BB)

In the mounting step (BB), light-emitting elements 30 arranged at predetermined positions on the wiring board 20 are mounted via individual pieces 16. The mounting state of the light-emitting elements 30 is similar to that in FIG. 3. As a method of mounting the light-emitting elements 30 on the wiring board 20, any of the connection methods used in known anisotropic conductive films such as thermocompression bonding may be selected as appropriate. Thus, the light-emitting elements 30 are able to be anisotropically connected on the wiring board 20 while the wiring board 20 is exposed without the presence of an anisotropic conductive adhesive layer between the light-emitting elements 30. In addition, by using a translucent board as the wiring board 20, superior optical transparency can be achieved compared to the case where an anisotropic conductive film is applied to the entire surface of the wiring board 20.

As described above, the method of manufacturing the display device according to the second embodiment can transfer and arrange the individual pieces 16 of the anisotropic conductive adhesive layer 12 to and on the light-emitting elements 30 with high precision and high efficiency by irradiation of the laser light, thereby reducing the tact time.

### MODIFICATION OF SECOND EMBODIMENT

As shown in FIG. 8, in the transfer step (A1) of the second embodiment described above, the individual pieces 16 of the anisotropic conductive adhesive layer 12 are transferred to the light-emitting elements 30; the embodiment, however, is not limited to the above and the individual pieces of the anisotropic conductive adhesive layer may be transferred to the light-emitting elements in units of electrodes. In other words, the first individual piece and the second individual piece may be transferred to the first conductivity-type electrode 32 on the p-side and the second conductivity-type electrode 33 on the n-side, respectively, of the light-emitting elements 30. This will improve the transparency of the display device.

### EXAMPLES

### 2. Example

In this example, an anisotropic conductive adhesive layer provided on a quartz glass plate was arranged to face a blank glass plate, and individual pieces of the anisotropic conductive adhesive layer were transferred to and arranged at predetermined positions on the blank glass plate by irradiating laser light from the base material side. The individual pieces arranged on the blank glass plate were then visually evaluated by using a metal microscope. It should be noted that examples of the present technology are not limited to these examples.

### PREPARATION OF ANISOTROPIC CONDUCTIVE ADHESIVE LAYER

An anisotropic conductive adhesive layer containing aligned conductive particles having an average particle size of 2.2 µm were laminated on a quartz glass plate to prepare an anisotropic conductive adhesive layer substrate having the anisotropic conductive adhesive layer of a thickness of 4 µm provided on the quartz glass plate. As a binder for the anisotropic conductive adhesive layer, 42 parts by mass of phenoxy resin (product name: PKHH, manufactured by Tomoe Engineering), 40 parts by mass of high-purity bisphenol A type epoxy resin (product name: YL-980, manufactured by Mitsubishi Chemical Corporation), 10 parts by mass of hydrophobic silica (product name: R202, manufactured by NIPPON AEROSIL), 3 parts by mass of acrylic rubber (product name: SG80H, manufactured by Nagase ChemteX Corporation), and 5 parts by mass of cationic polymerization initiator (product name: SI-60L, manufactured by Sanshin Chemical Industry) were blended, applied on a PET film with a thickness of 50 µm, and dried to prepare a resin layer. In the resulting resin layer, conductive particles (average particle size 2.2 µm, resin core metal coated fine particles, Ni plating 0.2 µm thick, manufactured by Sekisui Chemical) were aligned by the method described in JP 6187665 B so that the conductive particles roughly coincided with one interface of the resin layer. The alignment of the conductive particles in the plan view of the anisotropic conductive adhesive layer was such that the distance between the conductive particles was twice the particle size in the hexagonal lattice arrangement.

### TRANSFER OF ANISOTROPIC CONDUCTIVE ADHESIVE LAYER

A lifting device (MT-30C200) was used to transfer individual pieces of the anisotropic conductive adhesive layer to the blank glass plate. As described above, the lifting device includes a telescope that collimates pulsed laser light emitted from a laser device into parallel light, a shaping optical system that uniformly shapes the spatial intensity distribution of the pulsed laser light that has passed through the telescope, a mask that allows the pulsed laser light shaped by the shaping optical system to pass through in a predetermined pattern, a field lens positioned between the shaping optical system and the mask, and a projection lens that reduces and projects the laser light that has passed through the pattern of the mask onto a donor substrate, and holds the anisotropic conductive adhesive layer substrate, which is a donor substrate, on a donor stage, and the wiring board, which is a receptor substrate, on a receptor stage, the distance between the anisotropic conductive adhesive layer and the blank glass plate being 100 µm.

An excimer laser with an oscillation wavelength of 248 nm was used for the laser device. The pulse energy of the laser light was 600J, the fluence was 150 J/cm², the pulse width (irradiation time) was 30,000 picoseconds, the pulse frequency was 0.01 kHz, and the number of irradiation pulses was 1 pulse for each ACF piece. The pulse energy of the laser light imaged at the interface between the anisotropic conductive adhesive layer and the base material was 0.001 to 2J, the fluence was 0.001 to 2 J/cm², the pulse width (irradiation time) was 0.01 to 1 x 10⁹ picoseconds, the pulse frequency was 0.1 to 10,000 Hz, and the number of irradiation pulses was 1 to 30,000,000.

The mask had a pattern in which an array of windows of a predetermined size was formed at a predetermined pitch so that the projection at the interface between the anisotropic conductive adhesive layer of the anisotropic conductive adhesive layer substrate, which is a donor substrate and the quartz glass plate was an array of laser light having a size of 30 µm (length) x 40 µm (width) at a pitch of 120 µm (length) x 160 µm (width).

### EVALUATION OF TRANSFER

The measured reaction rate of individual pieces of anisotropic conductive adhesive layer arranged on the blank glass plate was 17.4%. The reaction rate was determined by the reduction rate of epoxy groups in individual pieces of the anisotropic conductive adhesive layer by using FT-IR. In other words, the reaction rate was determined based on the amount of the epoxy groups in the individual pieces reduced by laser light transfer from the amount before the transfer by measuring the absorption at 914 cm⁻¹ in the infrared absorption spectrum.

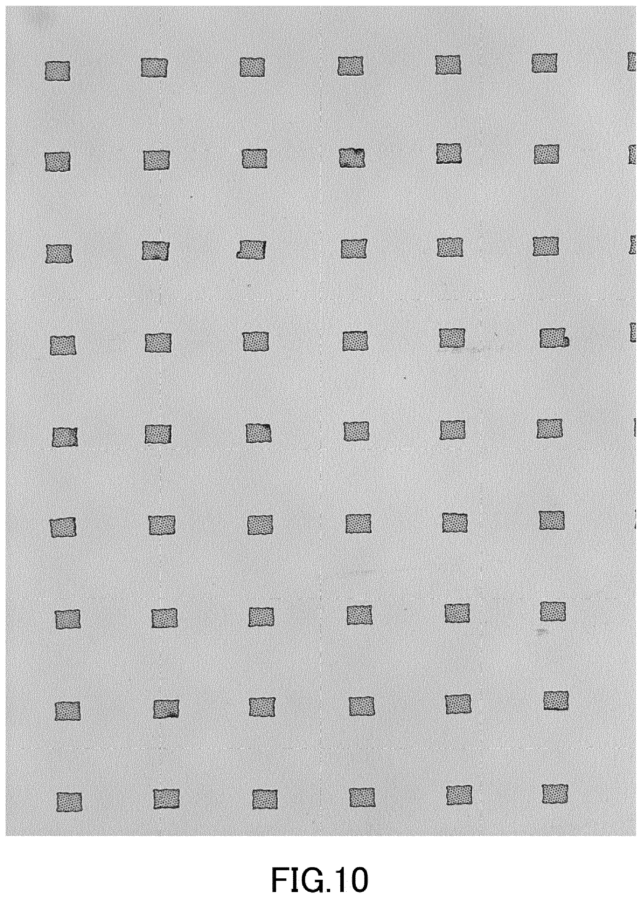

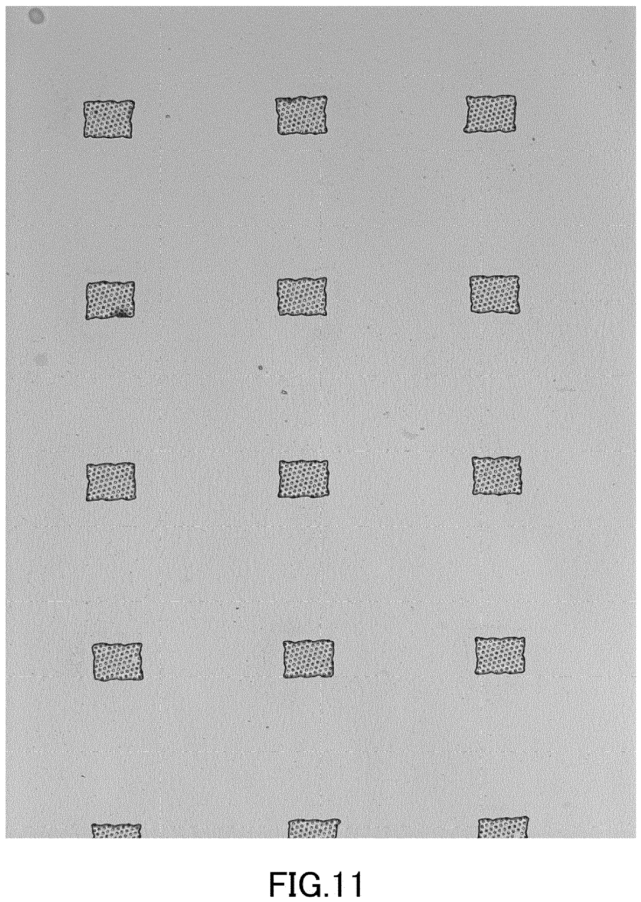

FIG. 10 is a metal micrograph showing the individual pieces of the anisotropic conductive adhesive layer arranged on the blank glass plate, and FIG. 11 is a magnified view of the metal micrograph shown in FIG. 10. As shown in FIGS. 10 and 11, it was confirmed that individual pieces of the anisotropic conductive adhesive layer were transferred to the blank glass plate according to the pattern of the mask. In other words, it was revealed that the individual pieces of the anisotropic conductive adhesive layer can be transferred and aligned with high precision and efficiency by the irradiation of laser light, and the tact time can be reduced.

While the embodiment of the present invention has been described in detail above, the present invention may be expressed as the following expressions (1) to (29) and (U1) to (U18) from different viewpoints.
(1) A method of manufacturing a display device, the method comprising:
   a transfer step of arranging an anisotropic conductive adhesive layer provided on a base material that is transparent to laser light and a wiring board to face each other, and irradiating laser light from the base material side so that individual pieces of the anisotropic conductive adhesive layer are transferred to and arranged at predetermined positions on the wiring board; and
   a mounting step of mounting light-emitting elements on the individual pieces arranged at the predetermined positions on the wiring board.
(2) The method of manufacturing a display device according to (1), wherein in the transfer step, the individual pieces of the anisotropic conductive adhesive layer are arranged in units of one pixel.
(3) The method of manufacturing a display device according to (1), wherein in the transfer step, the individual pieces of the anisotropic conductive adhesive layer are arranged in units of subpixels constituting one pixel.
(4) The method of manufacturing a display device according to (1), wherein in the transfer step, the individual pieces of the anisotropic conductive adhesive layer are arranged in units of multiple pixels.
(5) The method of manufacturing a display device according to (1), wherein in the transfer step, the individual pieces of the anisotropic conductive adhesive layer are arranged in units of electrodes of the light-emitting elements.
(6) The method of manufacturing a display device according to any one of (1) to (5), wherein the distance between the individual pieces arranged at the predetermined positions on the wiring board is 3 µm or more.
(7) The method of manufacturing a display device according to any one of (1) to (6), wherein the reaction rate of the individual pieces after the transfer step is 25% or less.
(8) The method of manufacturing a display device according to any one of (1) to (7), wherein the laser light has a wavelength of 180 to 360 nm; and
   the anisotropic conductive adhesive layer contains a resin having a maximum absorption wavelength in the wavelength range of 180 to 360 nm.
(9) The method of manufacturing a display device according to any one of (1) to (8), wherein the anisotropic conductive adhesive layer contains conductive particles.
(10) The method of manufacturing a display device according to any one of (1) to (9), wherein the anisotropic conductive adhesive layer is configured by aligning the conductive particles in a surface direction.
(11) The method of manufacturing a display device according to (9) or (10), wherein the conductive particles are absent in the region of the anisotropic conductive adhesive layer which is 0 to 0.05 µm in the thickness direction from the surface on which the base material is provided.
(12) The method of manufacturing a display device according to any one of (9) to (11), wherein the conductive particles are metal-coated resin particles formed by coating resin particles with metal, or metal-coated inorganic particles formed by coating inorganic particles with metal; and
   the coating thickness of the metal is 0.15 µm or more.
(13) The method of manufacturing a display device according to any one of (9) to (12), wherein the metal constituting the conductive particles includes a metal having a melting point of 1,400 °C or higher.
(14) A method of manufacturing a display device, the method comprising: a transfer step of arranging an anisotropic conductive adhesive layer provided on a base material that is transparent to laser light and light-emitting elements arranged on a transfer substrate to face each other, and irradiating laser light from the base material side to transfer individual pieces of the anisotropic conductive adhesive layer to the light-emitting elements arranged on the transfer substrate;
   a retransfer step of retransferring the light-emitting elements to which the individual pieces have been transferred to the wiring board; and
   a mounting step of mounting the light-emitting elements arranged at predetermined positions on the wiring board via the individual pieces.
(15) The method of manufacturing a display device according to (14), wherein in the transfer step, the individual pieces of the anisotropic conductive adhesive layer are transferred on the light-emitting elements in units of electrodes.
(16) The method of manufacturing a display device according to (14) or (15), wherein in the retransfer step, the light-emitting elements are transferred in units of subpixels constituting one pixel.
(17) A method of manufacturing a wiring board having an anisotropic conductive adhesive layer, the method comprising: arranging an anisotropic conductive adhesive layer provided on a base material and a wiring board to face each other, and irradiating laser light from the base material side to transfer individual pieces of the anisotropic conductive adhesive layer to predetermined positions on the wiring board.
(18) A method of manufacturing light-emitting elements having an anisotropic conductive adhesive layer, the method comprising: a transfer step of arranging an anisotropic conductive adhesive layer provided on a substrate and light-emitting elements arranged on a transfer substrate to face each other, and irradiating laser light from the base material side to transfer individual pieces of the anisotropic conductive adhesive layer to the light-emitting elements arranged on the transfer substrate.
(19) A film-shaped anisotropic conductive adhesive layer to be used for transfer by laser lift-off.
(20) The film-shaped anisotropic conductive adhesive layer according to (19) containing conductive particles.
(21) The film-shaped anisotropic conductive adhesive layer according to (20), wherein the conductive particles are absent in the region which is 0 to 0.05 µm in the thickness direction from the surface of the base material side, which is provided during transfer by the laser lift-off.
(22) The film-shaped anisotropic conductive adhesive layer according to (20) or (21), wherein the conductive particles are metal-coated resin particles formed by coating resin particles with metal, or metal-coated inorganic particles formed by coating inorganic particles with metal; and
   the coating thickness of the metal is 0.15 µm or more.
(23) The film-shaped anisotropic conductive adhesive layer according to any one of (20) to (22), wherein the metal constituting the conductive particles contains a metal with a melting point of 1,400 °C or higher.
(24) The film-shaped anisotropic conductive adhesive layer according to any one of (20) to (23), wherein the metal constituting the conductive particles contains nickel, palladium, or ruthenium.
(25) A base material having an anisotropic conductive adhesive layer laminated thereon to be used for laser lift-off transfer.
(26) Application of an anisotropic conductive adhesive layer to an anisotropic conductive adhesive layer for laser lift-off transfer.
(27) Application of an anisotropic conductive adhesive layer to manufacturing of an anisotropic conductive adhesive layer for laser lift-off transfer.
(28) Application of an anisotropic conductive adhesive layer to manufacturing of a base material having a laminated anisotropic conductive adhesive layer laminated thereon to be used for laser lift-off transfer.
(29) Application of an anisotropic conductive adhesive layer to laser lift-off.
   (U1) A system for manufacturing a display device, the system comprising:
      a transfer mechanism that arranges an anisotropic conductive adhesive layer provided on a base material that is transparent to laser light and a wiring board to face each other, and irradiates laser light from the base material side so that individual pieces of the anisotropic conductive adhesive layer are transferred to and arranged at predetermined positions on the wiring board; and
      a mounting mechanism that mounts light-emitting elements on the individual pieces arranged at predetermined positions on the wiring board.
   (U2) The system for manufacturing a display device according to (U1), wherein in the transfer mechanism, the individual pieces of the anisotropic conductive adhesive layer are arranged in units of one pixel.
   (U3) The system for manufacturing a display device according to (U1), wherein in the transfer mechanism, the individual pieces of the anisotropic conductive adhesive layer are arranged in units of subpixels constituting one pixel.
   (U4) The system for manufacturing a display device according to (U1), wherein in the transfer mechanism, the individual pieces of the anisotropic conductive adhesive layer are arranged in units of multiple pixels.
   (U5) The system for manufacturing a display device according to (U1), wherein in the transfer mechanism, the individual pieces of the anisotropic conductive adhesive layer are arranged in units of electrodes of the light-emitting elements.
   (U6) The system for manufacturing a display device according to any one of (U1) to (U5), wherein the distance between the individual pieces arranged at the predetermined positions on the wiring board is 3 µm or more.
   (U7) The system for manufacturing a display device according to any one of (U1) to (U6), wherein the reaction rate of the individual pieces after transfer by the transfer mechanism is 25% or less.
   (U8) The system for manufacturing a display device according to any one of (U1) to (U7), wherein the laser light has a wavelength of 180 to 360 nm; and
      the anisotropic conductive adhesive layer contains a resin having a maximum absorption wavelength in the wavelength range of 180 to 360 nm.
   (U9) The system for manufacturing a display device according to any one of (U1) to (U8), wherein the anisotropic conductive adhesive layer contains conductive particles.
   (U10) The system for manufacturing a display device according to (U9), wherein the anisotropic conductive adhesive layer is configured by aligning the conductive particles in a surface direction.
   (U11) The system for manufacturing a display device according to (U9) or (U10), wherein the conductive particles are absent in the region of the anisotropic conductive adhesive layer which is 0 to 0.05 µm in the thickness direction from the surface on which the base material is provided.
   (U12) The system for manufacturing a display device according to any one of (U9) to (U11), wherein the conductive particles are metal-coated resin particles formed by coating resin particles with metal, or metal-coated inorganic particles formed by coating inorganic particles with metal; and
      the coating thickness of the metal is 0.15 µm or more.
   (U13) The system for manufacturing a display device according to any one of (U9) to (U12), wherein the metal constituting the conductive particles includes a metal having a melting point of 1,400 °C or higher.
   (U14) A system for manufacturing a display device, the system comprising: a transfer mechanism that arranges an anisotropic conductive adhesive layer provided on a base material that is transparent to laser light and light-emitting elements arranged on a transfer substrate to face each other, and irradiates laser light from the base material side to transfer individual pieces of the anisotropic conductive adhesive layer to the light-emitting elements arranged on the transfer substrate;
      a retransfer mechanism that retransfers the light-emitting elements to which the individual pieces have been transferred to the wiring board; and
      a mounting mechanism that mounts the light-emitting elements arranged at predetermined positions on the wiring board via the individual pieces.
   (U15) The system for manufacturing a display device according to (U14), wherein in the transfer mechanism, the individual pieces of the anisotropic conductive adhesive layer are transferred on the light-emitting elements in units of electrodes.
   (U16) The system for manufacturing a display device according to (U14) or (U15), wherein in the retransfer mechanism, the light-emitting elements are transferred in units of subpixels constituting one pixel.
   (U17) A system for manufacturing a wiring board with an anisotropic conductive adhesive layer, including a mechanism that arranges an anisotropic conductive adhesive layer provided on a base material and a wiring board to face each other, and irradiates laser light from the base material side so that individual pieces of the anisotropic conductive adhesive layer are transferred to predetermined positions on the wiring board.
   (U18) A system for manufacturing a wiring board with an anisotropic conductive adhesive layer, including a transfer mechanism that arranges an anisotropic conductive adhesive layer provided on a base material and light-emitting elements arranged on a transfer substrate to face each other, and irradiates laser light from the base material side to transfer individual pieces of the anisotropic conductive adhesive layer to the light-emitting elements arranged on the transfer substrate.

Each of the configuration requirements in many of the previously described embodiments may be subdivided and the subdivided configuration requirements may be incorporated into these (1) to (29) and (U1) to (U18), individually or in combination.

### REFERENCE SIGNS LIST

10 substrates, 11 base material, 12 anisotropic conductive adhesive layer, 12a individual pieces, 13 conductive particles, 20 wiring boards, 21 base material, 22 first electrode, 23 second electrode, 30 light-emitting element, 31 body, 32 first conductivity-type electrode, 33 second conductivity-type electrode, 40 transfer substrate, 41 base material

## Claims

1. A method of manufacturing a display device, the method comprising:
a transfer step of arranging an anisotropic conductive adhesive layer provided on a base material that is transparent to laser light and a wiring board to face each other, and irradiating laser light from the base material side so that individual pieces of the anisotropic conductive adhesive layer are transferred to and arranged at predetermined positions on the wiring board; and
a mounting step of mounting light-emitting elements on the individual pieces arranged at the predetermined positions on the wiring board.

2. The method of manufacturing a display device according to claim 1, wherein in the transfer step, the individual pieces of the anisotropic conductive adhesive layer are arranged in units of one pixel.

3. The method of manufacturing a display device according to claim 1, wherein in the transfer step, the individual pieces of the anisotropic conductive adhesive layer are arranged in units of subpixels constituting one pixel.

4. The method of manufacturing a display device according to claim 1, wherein in the transfer step, the individual pieces of the anisotropic conductive adhesive layer are arranged in units of multiple pixels.

5. The method of manufacturing a display device according to claim 1, wherein in the transfer step, the individual pieces of the anisotropic conductive adhesive layer are arranged in units of electrodes of the light-emitting elements.

6. The method of manufacturing a display device according to any one of claims 1 to 5, wherein the distance between the individual pieces arranged at the predetermined positions on the wiring board is 3 µm or more.

7. The method of manufacturing a display device according to any one of claims 1 to 6, wherein the reaction rate of the individual pieces after the transfer step is 25% or less.

8. The method of manufacturing a display device according to any one of claims 1 to 7, wherein
the laser light has a wavelength of 180 to 360 nm; and
the anisotropic conductive adhesive layer contains a resin having a maximum absorption wavelength in the wavelength range of 180 to 360 nm.

9. The method of manufacturing a display device according to any one of claims 1 to 8, wherein the anisotropic conductive adhesive layer contains conductive particles.

10. The method of manufacturing a display device according to claim 9, wherein the anisotropic conductive adhesive layer is configured by aligning the conductive particles in a surface direction.

11. The method of manufacturing a display device according to claim 9 or 10, wherein the conductive particles are absent in the region of the anisotropic conductive adhesive layer which is 0 to 0.05 µm in the thickness direction from the surface on which the base material is provided.

12. The method of manufacturing a display device according to any one of claims 9 to 11, wherein
the conductive particles are metal-coated resin particles formed by coating resin particles with metal, or metal-coated inorganic particles formed by coating inorganic particles with metal; and
the coating thickness of the metal is 0.15 µm or more.

13. The method of manufacturing a display device according to any one of claims 9 to 12, wherein the metal constituting the conductive particles includes a metal having a melting point of 1,400 °C or higher.

14. A method of manufacturing a display device, the method comprising:
a transfer step of arranging an anisotropic conductive adhesive layer provided on a base material that is transparent to laser light and light-emitting elements arranged on a transfer substrate to face each other, and irradiating laser light from the base material side to transfer individual pieces of the anisotropic conductive adhesive layer to the light-emitting elements arranged on the transfer substrate;
a retransfer step of retransferring the light-emitting elements to which the individual pieces have been transferred to the wiring board; and
a mounting step of mounting the light-emitting elements arranged at predetermined positions on the wiring board via the individual pieces.

15. The method of manufacturing a display device according to claim 14, wherein in the transfer step, the individual pieces of the anisotropic conductive adhesive layer are transferred on the light-emitting elements in units of electrodes.

16. The method of manufacturing a display device according to claim 14 or 15, wherein in the retransfer step, the light-emitting elements are transferred in units of subpixels constituting one pixel.

17. A method of manufacturing a wiring board having an anisotropic conductive adhesive layer, the method comprising: arranging an anisotropic conductive adhesive layer provided on a base material and a wiring board to face each other, and irradiating laser light from the base material side to transfer individual pieces of the anisotropic conductive adhesive layer to predetermined positions on the wiring board.

18. A method of manufacturing light-emitting elements having an anisotropic conductive adhesive layer, the method comprising: a transfer step of arranging an anisotropic conductive adhesive layer provided on a substrate and light-emitting elements arranged on a transfer substrate to face each other, and irradiating laser light from the base material side to transfer individual pieces of the anisotropic conductive adhesive layer to the light-emitting elements arranged on the transfer substrate.
